# EUROPEAN PATENT SPECIFICATION

(11) **EP 2 686 752 B1**
(45) Date of publication and mention of the grant of the patent: **05.10.2016**
(21) Application number: 12718744.1
(22) Date of filing: 14.03.2012
(51) Int. Cl.: G06F 1/20, H01L 23/367, H05K 7/20

(54) **LIQUID COOLING DEVICE FOR ELECTRONIC CARDS**
FLÜSSIGKEITSKÜHLUNGSVORRICHTUNG FÜR ELEKTRONISCHE KARTEN
DISPOSITIF DE REFROIDISSEMENT LIQUIDE POUR CARTES ÉLECTRONIQUES

(30) Priority: 15.03.2011 IT UD20110040
(43) Date of publication of application: 22.01.2014
(73) Proprietor: Eurotech SPA, 33020 Amaro (IT)
(72) Inventor: ROSSI, Mauro, I-33013 Gemona del Friuli (IT)
(74) Representative: Petraz, Gilberto Luigi
(86) International application number: PCT/IB2012/000471
(87) International publication number: WO 2013/050813

(56) References cited:
- EP-A1- 0 449 640
- JP-A- 63 299 258
- US-A- 3 631 325
- US-A1- 2006 250 772
- US-A1- 2008 116 571
- US-A1- 2008 291 630
- US-B1- 6 496 373

## Description

### FIELD OF THE INVENTION

The present invention concerns a liquid cooling device for electronic cards and in particular the electronic modules mounted on them, such as for example memory modules, by means of cooling plates, also known as "cold plates", which are passed through by a cooling liquid.

In particular, the cooling device is suitable to be applied in a high performance processing units or supercomputers, in which a high degree of integration of the electronics is required.

Merely as an example, the present invention can be applied to standard type memory modules such as DIMM (Dual In-line Memory Module), SIMM (Single In-line Memory Module), SO-DIMM (Small Outline Dual In-line Memory Module) or other types of module memory, or electronic modules having similar or comparable shape or layout to those of the memory modules indicated above.

### BACKGROUND OF THE INVENTION

The need to cool electronic cards is known, and in particular the electronic components mounted on them, such as integrated circuits, microprocessors and memory modules, to prevent functioning temperature limit values from being exceeded above which malfunctions and irreversible damage can occur, or to improve the performances of the electronic cards.

As well as the traditional cooling using forced air, heat dissipation techniques are known, based on the use of heat-carrying liquids.

This technological orientation has been caused by the fact that in the field of super computers there has been an increasing demand for a high degree of electronic integration, that is, an increase in the power of calculation per unit of volume. From this derives the need to place the electric components, and in particular the memory modules, at very reduced distances from each other, not leaving space for a sufficient passage of air, thus rendering a cooling of this type impracticable.

It is also known that the memory modules are inserted in suitable support connectors or slots, provided on a printed circuit board, or PCB, disposed substantially vertical and parallel to each other and separated by a hollow space through which a flow of forced air is conveyed. On the contrary, in the most recent technologies, to cool such boards or cards, it is known to place liquid cooling devices coupled to each individual card; the liquid cooling devices are placed in contact or in proximity with the so-called hot spots of the various electronic components and the PCB itself, in order to remove the heat and improve the functioning conditions thereof.

Cooling devices of this type can provide to use cooling plates, also called cold plates, which comprise integrated pipes disposed in a coil and through which a cooling liquid passes.

It is also known that the memory modules associated to the PCB through the slots present on the boards can be cooled by means of the cold plates.

The American patent application US-A-2006/0250722 describes a liquid cooling device for memory modules of electronic cards; the memory modules are housed substantially vertical in respective connectors, positioned at a certain predefined distance between one connector and the adjacent one, on the electronic card or PCB, to define a hollow space.

A cold plate provided with pipes through which a cooling liquid passes is disposed on the top of the memory modules, substantially perpendicular to the development of the memory modules, and a plurality of fins with which the plate itself is provided, extends substantially orthogonal thereto, and occupy a substantially central position of the hollow space between one memory module and the following one.

The cold plate and the fins are made of heat-conductive metal material to optimize heat exchange.

Between a fin and the corresponding memory module a layer of heat interface is interposed, made of soft heat-conductive material conformable with the surface profile of the memory module when subjected to pressure; this contacts the components of the memory module and allows a suitable and adequate heat exchange.

Document JP-A-63299258 discloses a cooling structure for semiconductor elements mounted on printed circuit boards, such as memory modules, comprising a heat conductive plate and inclined flat conductive plates arranged between the printed circuit boards. Cooling pipes are provided substantially perpendicular to the longitudinal direction of the printed circuit boards.

This solution, providing pipes orthogonal to the electronic elements to be cooled, does not offer an efficient high heat exchange, since the pipes affect only a limited part of the elements to be cooled and moreover the elements to be cooled are not in direct contact with the dissipation elements.

Within the framework of these technologies, it is also known to provide that the electronic cards are disposed adjacent to each other inside containers, or subracks, at a predefined pitch. To increase the level of integration of the electronics, it is necessary to reduce the pitch between adjacent electronic cards which, simply to give an example, is typically a few centimeters.

It is also known that, in the most common version, the memory modules have a height of about 30 mm, which therefore limits the level of integration on the electronic card, that is, the minimum pitch between two cards.

Standardized memory modules are also known, with a reduced height compared with the traditional standard versions, also defined Ultra Low Profile (ULP). In spite of this, the overall height from the surface of the PCB of such modules when inserted into the respective connectors does not allow to greatly reduce the bulk in overall height of the electronic card, and hence to obtain a desired degree of electronic integration.

One purpose of the present invention is to increase the degree of electronic integration in electronic cards, to obtain a greater computing power per unit of volume while still guaranteeing optimum heat exchange and cooling of the electronic cards and in particular of the hots spots of the memory modules.

Another purpose is to achieve a liquid cooling device for electronic cards which is simple and economical, and which allows to use memory modules normally present on the market.

Another purpose of the present invention is to achieve a cooling device that does not reduce the flexibility and interchangeability of the memory modules that can be installed on the PCB in subsequent steps.

Another purpose of the present invention is to achieve a cooling device suitable to be applied on any electronic module similar or comparable to memory modules in shape and type.

The Applicant has devised, tested and embodied the present invention to overcome the shortcomings of the state of the art and to obtain these and other purposes and advantages.

### SUMMARY OF THE INVENTION

The present invention is set forth and characterized in the independent claims, while the dependent claims describe other characteristics of the invention or variants to the main inventive idea.

In accordance with the above purposes, a liquid cooling device for electronic cards according to the present invention is used to cool the hot spots of electronic cards, the hot spots represented substantially by electronic processing components, for example memory modules which have to be suitably cooled to avoid being damaged.

The electronic cards to which the cooling device according to the invention is applied comprises a plurality of electronic modules, such as memory modules or electronic components having shape and/or size similar or comparable to memory modules, which are associated to a printed circuit board; the board comprises support elements configured to position the electronic modules inclined with respect to the printed circuit board by a first acute angle and comprising connection elements of a shape mating with the electronic modules, so as to house inside them part of the electronic modules in order to connect to the printed circuit board.

Here and hereafter in the description any reference to memory modules also includes generic electronic modules similar or comparable to memory modules with regard to shape or sizes or layout

As we said, to reduce the bulk in height of the whole electronic card, the memory modules to which the invention is applied are disposed inclined with respect to the latter by an acute angle comprised, for example, between 10° and 40°, advantageously between 20° and 40°, even more advantageously between 20° and 25°.

In order to further reduce the bulk in height of the electronic card, it is advantageous to provide the use of electronic components of a limited height, for example memory modules of the type known in the state of the art as "low profile", that is, with a limited height.

The cooling device according to the present invention comprises a heat exchange means, conformed substantially as a plate, to cool in contact at least a portion of each of the electronic modules protruding from a corresponding connection element and bearing one or more electronic components to be cooled. The heat exchange means is provided with at least a cooling circuit comprising pipes which extend parallel to the longitudinal development of the connection elements of the electronic modules and through which a cooling liquid flows. The heat exchange means has a heat exchange surface which can be positioned, when in use, substantially parallel to the printed circuit board.

According to one feature of the present invention, the heat exchange surface of the heat exchange plate comprises a plurality of cavities suitable, during use, to contact the hot spots of the electronic card. The cavities develop in a main direction substantially parallel to the pipes, each cavity having at least a contact surface inclined with respect to the heat exchange surface by a second angle. The device also comprises interposition means which can be inserted in the cavities to be interposed between the inclined contact surfaces and the support elements, so that each one cooperates directly in contact both with the contact surface of the corresponding cavity of the heat exchange surface and also with the corresponding portion to be cooled of each of the electronic modules protruding from the connection elements which has the electronic components.

In this way, the interposition means provide, on the one hand, to contact both the hot spots of the memory modules and the heat exchange means thus removing the heat and preventing problems of overheating, and on the other hand the interposition means are disposed in contact with the support elements to transfer possible mechanical stresses acting on the electronic components of the memory modules due, for example, to possible impacts of the heat exchange means caused by the positioning under pressure against the printed circuit board. This allows to avoid damaging the welded connections of connectors mounted on the printed circuit board and suitable to allow to house the memory modules.

According to another feature, the interposition means also comprise at least a first heat interface element with heat-conductive characteristics, also called "Thermal Interface Material", or TIM, which is interposed in direct contact between a first surface to be cooled of the corresponding electronic module and the contact surface, and a rigid interposition element interposed between at least one memory module and the support element and shaped to cover a top end, and a second surface, opposite the first surface, of the corresponding electronic module, so as to completely surround at least the corresponding portion to be cooled of the electronic modules protruding from the connection elements; in this case it is the rigid interposition element which provides to transfer the mechanical stresses acting on the memory modules toward the printed circuit board.

According to an advantageous form of embodiment, the first heat interface element is made of high deformability heat-conductive material, also indicated as Soft-TIM, so that in the assembly step the heat exchange means can be put under pressure and in safe contact against electronic components associated to the memory modules, so as to guarantee an optimum heat exchange by conduction.

According to a variant, the first interface heat element and the rigid interposition element are made in a single piece and conformed to surround the memory module. In this case an element is obtained in a single piece, conformed substantially as a hood which, at the time the memory module is installed on the printed circuit board, can be associated in a rapid and secure way to the latter.

It is advantageous to provide, in particular for memory modules which require cooling on both faces, for example in the case of memory modules provided with electronic components on both its opposite sides, that the rigid interposition element is conformed to surround at least partly, during use, the at least one memory module.

In particular, the rigid interposition element is associated to the memory module to cover its surface portions which, also after having associated the memory module to the connector, remain exposed. In this case, a second heat interface element and a third heat interface element are associated, internally on opposite sides, to the rigid interposition element and are suitable to contact both surfaces of the memory module on the level of its electronic components.

The rigid interposition element is disposed in contact externally on one side with the first heat interface element and on the opposite side with the support element.

In this case too, it is possible to provide that the interface element, the first, the second and the third interface element are made in a single body.

Indeed it can be provided to make an interface layer, also made of heat conductive material with high deformability, which covers the surface of the interposition element, either completely or at least the surfaces which are in contact with the memory module and with the heat exchange means. In this way an interposition element is obtained which is easy to handle and install, having an internal core of a substantially rigid material which is suitable to transfer the stresses which act on the memory modules inclined toward the printed circuit board, and a soft interface layer which as well as having heat conductive characteristics guarantees a secure contact with the components of the memory module, preventing the danger of their being damaged but, at the same time, allowing an optimum heat exchange.

According to another feature, the function of the support element is performed by the connection elements of the memory modules so that it is possible to disposed several memory modules in succession, adjacent and inclined, partly overlapping so that one is placed in the shadow of the other, and the connection element of a memory module which follows or precedes acts as a support element for the adjacent memory module which precedes or follows.

In particular, considering a pair of contiguous and overlapping connection elements, the interposition means associated to a determinate first connection element overlapping a second connection element press directly and rest on the following connection element below.

According to another feature, the second angle of inclination of the contact surface is substantially equal to the first angle of inclination of the memory modules; in this way it is possible to optimize the heat exchange surface, obtaining a much larger contact surface.

In particular, the amplitude of the first angle of inclination of the memory modules is optimized to maximize the contact heat exchange surface between the memory module and dissipation means and the need to contain the overall bulk of the electronic cards. The particular amplitude of the angle also allows to use connectors of a standard type and available on the market.

According to a variant form of embodiment, the support elements comprise spacer elements protruding from the printed circuit board and configured to support the portions of each of the electronic modules protruding from the connection elements, so as to support the stresses imposed by the heat exchange mean in contact and to discharge them on the printed circuit board.

According to one form of embodiment, each of the connection elements is provided with a connection portion to the printed circuit board.

Moreover, in another variant, each of the connection elements is provided with an insertion portion provided with a slot in which parts of the electronic modules are housed.

According to a specific variant, the portions of each of the electronic modules protruding from the connection elements protrude from the corresponding slots of the insertion portions of the connection elements.

In a variant embodiment, considering a pair of contiguous and overlapping connection elements, the interposition means associated to the first connection element press directly and rest on the connection portion of the following connection element below.

### BRIEF DESCRIPTION OF THE DRAWINGS

These and other characteristics of the present invention will become apparent from the following description of a preferential form of embodiment, given as a non-restrictive example with reference to the attached drawings wherein:
- fig. 1 is a perspective view of a container for electronic cards provided with a liquid cooling device according to the present invention;
- fig 2 is a partial perspective view of an electronic card on which the cooling device according to the present invention is disposed during use;
- fig. 3 is a lateral section view of a cooling device according to the present invention associated to an electronic card;
- fig. 4 is an enlarged detail of fig. 3;
- fig. 5 is a variant of fig. 4;
- fig. 6 is another variant of fig. 4.

To facilitate comprehension, the same reference numbers have been used, where possible, to identify identical common elements in the drawings. It is understood that elements and characteristics of one form of embodiment can conveniently be incorporated into other forms of embodiment without further clarifications.

### DETAILED DESCRIPTION OF SOME PREFERENTIAL FORMS OF EMBODIMENT

With reference to the attached drawings, a liquid cooling device 10 is associated with electronic cards 11 that are suitable to be disposed inside a container 12, also called sub-rack, in an aligned order with respect to each other.

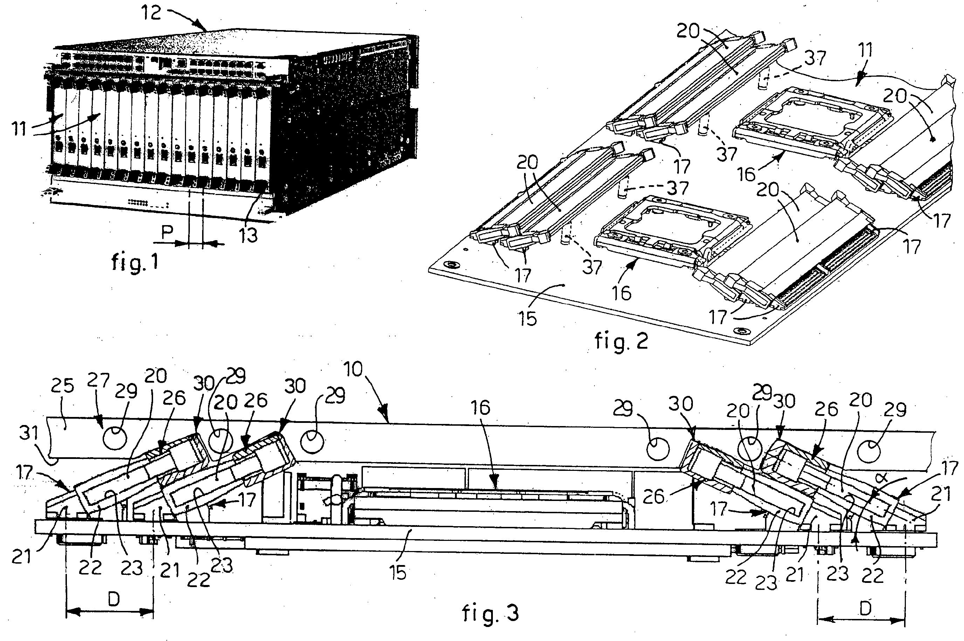

In particular (fig. 1), the container 12 is provided with a plurality of seatings 13 provided with guides that allow to insert the electronic cards 11 according to a determinate pitch P, which to give an example is comprised between 20 mm and 30 mm, preferably 25.4 mm (1 inch) or less. Each container 12 is subsequently mounted, in a known manner, inside a containing cupboard not shown in the drawings.

Each electronic card 11 (fig. 2) comprises a circuit board printed according to a predetermined topological and circuit pattern, also called PCB 15, on which electronic components 16 and connectors 17 are welded, suitable to allow to connect memory modules 20 of a standard type.

The connectors 17 are disposed inclined by a first acute angle α with respect to the PCB 15 and in series with each other, in this case for example in pairs, so as to position the memory modules 20 inclined and partly overlapping at the head and tail.

In this case, each of the connectors 17 (fig. 3) is provided with a connection portion 21, which is provided in a known manner with a plurality of feet that are welded to the PCB 15, and with an insertion portion 22 provided with slots 23 into each of which a corresponding memory module 20 can be inserted.

The insertion portions 22 and respective slots 23 extend substantially angled with respect to the PCB 15 by said first acute angle α with an amplitude comprised in a range between 10° and 40°, preferably between 20° and 25°.

In the case shown in fig. 2, the connectors 17 and the respective memory modules 20 are grouped together in groups of two, and are disposed in four zones of the PCB 15, although it is clear that the number of connectors 17 and the disposition thereof could be different, for example in groups of three or more memory modules 20 disposed parallel to each other.

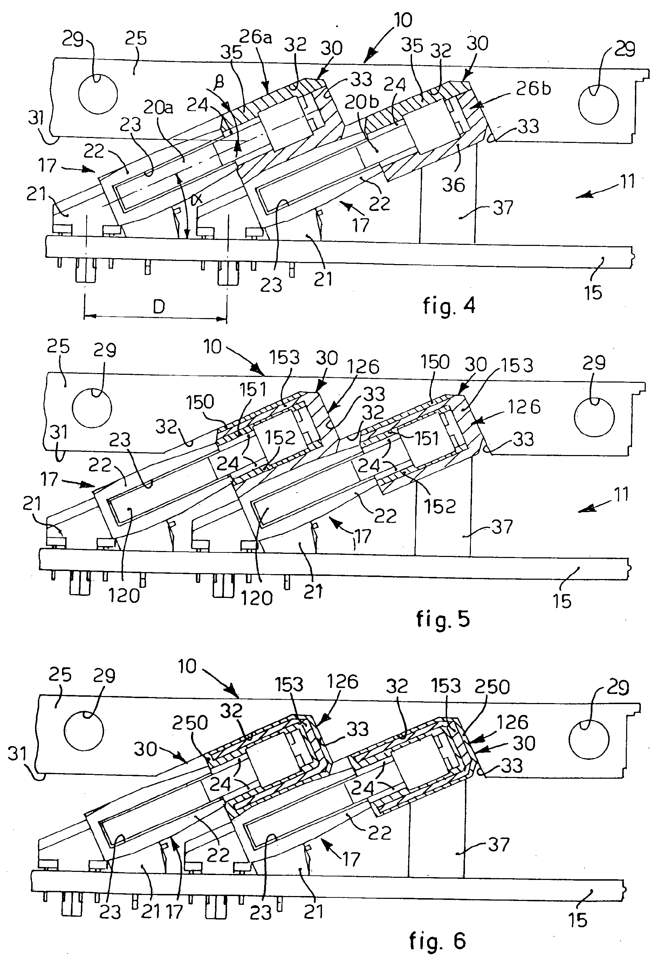

The memory modules 20 are the standard type, substantially known, and are provided with electronic components 24, such as for example memory chips and passive components, which are disposed either on one side of the memory module 20 (fig. 4), and can therefore be cooled on one side only, or on both sides (fig. 5), which in this case requires a cooling on both sides. The electronic components 24 are provided on the portions of the memory modules that protrude from the connectors 17, in this case from the corresponding slots 23 of the insertion portions 22.

All or some of the electronic components 24 present on the memory modules 20 represent hot spots of the electronic card 11 and therefore must be suitably cooled to avoid malfunction or damage.

Furthermore, the memory modules 20 are advantageously of the low profile type (ULP), that is, they have a height of less than 20 mm, which, if they are inserted inside the slots 23 of the connectors 17, allows to contain the overall transverse sizes of the electronic card 11 and hence the pitch P between adjacent electronic cards.

The cooling device 10 (fig. 3) is associated to the electronic card 11 and comprises a cooling plate 25, also called cold plate, and a plurality of interposition means 26, having the function of heat conductors, which are associated with each memory module 20 as will be described hereafter.

The cold plate 25 is provided with a tubular mesh 27, which develops inside the cold plate 25 according to a prefixed geometry, and in which respective pipes 29 extend at least parallel to the longitudinal development of the connectors 17 and therefore, in use, of the memory modules 20, that is, near the hot points of the electronic card 11 consisting of the memory modules, to provide the necessary heat exchange.

As shown for example in fig. 3, according to a non-restrictive variant of the present invention, the pipes 29 could be disposed in the cold plate 25 so as to be positioned not only at the beginning and at the end but also intermediate between the connectors 17 and therefore, in use, between the corresponding memory modules 20. Figs. 4 - 6, on the contrary, show the solution, for convenience but without limiting the field of the present invention, in which the pipes 29 are disposed only at the beginning and at the end of the connectors 17 and corresponding memory modules 20.

The cold plate 25 extends substantially for the whole surface occupied by the PCB 15 and is provided, on a heat exchange surface 31 thereof, in use disposed facing the PCB 15, with a plurality of shaped cavities 30 that develop in a main direction substantially parallel to the pipes 29 and therefore in use extend coordinated with the disposition of the memory modules 20 that are mounted on the PCB 15 and that, in the assembled position, are disposed in cooperation with the interposition means 26.

In particular, each of the shaped cavities 30 (figs. 4 and 5) is provided with a first surface 32 and a second surface 33, wherein the first surface 32 is angled with respect to the heat-exchange surface 31 by a second angle β in this case for example substantially equal to the angle α, while the second surface 33 is substantially orthogonal with respect to the first surface 32.

Each of the first surfaces 32, in use, is disposed in contact with the interposition means 26; since in the mounted position the surfaces 32 are inclined by the same angle as the memory modules 20, this allows to optimize the heat-exchange surface, thus obtaining a plate with a high dissipation capacity and high heat efficiency.

The cold plate 25 is advantageously made of heat-conductive metal material, to give an example aluminum, copper or alloys thereof, and can be made using the same methods as traditional heat exchangers, that is, using pressfit-tube techniques or by holing a plate of compact material.

It is advantageous to provide that the cold plate 25 is made in a single piece, without any transverse apertures that reduce its heat yield and the cost of manufacture. The thickness of the cold plate 25 depends on the depth of the shaped cavities 30 which in turn depends on the amplitude of the angle α and on the need to maximize the contact surface with the interposition means 26. The thickness of the cold plate 25 also depends on the technology used to make the shaped cavities.

In any case, the overall transverse bulk of the combined cold plate 25 and the PCB 15 is substantially equal to the pitch P at which the electronic cards 11 are disposed in the container 12.

If memory modules 20 are used with electronic components 24 mounted only on one surface (fig. 4), each of the interposition means 26 comprises a heat interface element 35 which, in use, is disposed in direct contact with a first upper surface to be cooled of the memory module 20, and a substantially rigid interposition element 36 conformed to cover the head end of the memory module 20 and a second lower surface, in this case without components.

The heat interface element 35 is made of heat-conductive material of a known type, having high deformability and high heat conductivity, to give an example silicone or non-silicone polymer, while the interposition element 36 is made of rigid material such as plastic or metal.

If the interposition element 36 is made of metal material, it is necessary to provide that its surface, which in use is put in contact with the memory module 20, is coated with an electric insulator and also sufficiently resistant to small abrasions that can occur during insertion or removal of the interposition element 36 on the memory module 20.

The cold plate 25 is disposed above the PCB 15, substantially parallel to the latter, so that the shaped cavities 30 are disposed in contact with the interposition means 26 when they are installed on the memory modules, and is attached thereto with known connection means.

In particular, the cold plate 25 is attached to the PCB 15 so as to take the heat interface elements 35 in compression against the cold plate 25, and to guarantee a direct heat exchange through conduction.

The cold plate 25 can be applied to or removed from the PCB 15 without necessarily requiring any interventions to remove or modify the disposition of the electronic components 16 and/or the memory modules 20 present thereon.

With reference to fig. 4, this shows the application of the cold plate 25 to a first memory module 20a and a second memory module 20b, both of which are disposed adjacent to each other and inclined by the angle α. A first interposition means 26a and a second interposition means 26b are respectively associated with the first memory module 20a and the second memory module 20b.

The rigid interposition element 36 of the first interposition means 26a is put in contact against the insertion portion 22 of the second memory module 20b, so that when the cold plate 25 is put under pressure above the memory modules 20, the stresses are transferred from the first memory module 20a to the insertion element 22 of the second memory module 20b, in this way preventing any damage to the connections of the connector 17 of the first memory module 20a.

In this way the connector 17 of the second memory module 20b functions as a support element for the first memory module 20a.

Spacer support elements, also called pillars 37, are associated to the second memory module 20b, and in particular to the second interposition means 26b; they support the stresses imposed by the cold plate 25 and discharge the load on the PCB 15, preventing any damage to its connectors 17.

The pillars 37 (fig. 2) are substantially cylindrical in shape and the upper end is rounded so as not to damage the memory module on which they act; they are attached to the PCB 15 in a known manner, for example by means of threaded connections.

In an advantageous form of embodiment, the heat interface element 35 and the rigid interposition element 36 are made in a single piece so as to constitute substantially a hood, to be inserted at the end of each memory module 20, covering the area of the memory modules visible when inserted into the corresponding connectors.

In another form of embodiment (fig. 5), indispensable if it is desired to dissipate the heat from the memory module on both sides of the corresponding PCB 15, for example if memory modules 120 are used, provided with electronic components 24 associated to both its surfaces, an interposition means is indicated in its entirety by the reference number 126 and comprises a first interface element 150, in use in direct contact with the first surface 32 of the cavity 20, a second interface element 151 in contact with the upper surface of the memory module 120, and a third interface element 152 in use in contact against the lower surface of the memory module 120.

The first 150, second 151 and third interface element 152 perform the function of transferring/removing the heat generated by the electronic components 24 of each memory module 20 and are made of heat-conductive material of a known type having high deformability and high heat conductivity, for example silicone or non-silicone polymer.

The interposition mean 126 also comprises a rigid element 153 that surrounds the end of the memory module 120 and is disposed externally with respect to the second and third interface element 151 and 152. In other words, the rigid element 153 is substantially U-shaped and in use is located in cooperation with the end of the memory module 120 and its internal surface is covered by the second and third layer of heat interface 151, 152 which contact the electronic components 24 of the memory module 120.

The rigid element 153, unlike what was described for fig. 4, is made of highly heat-conductive material and with good elasticity, for example harmonic steel or other alloys.

The property of heat-conductivity is indispensable to allow the dissipation of the heat also from the side of the memory module 120 not facing the cold plate 25.

The property of elasticity of the material allows the rigid element 153 to deform so as to dispose its sides, in use, in secure contact against the two surfaces of the memory modules 120, in order to discharge the stresses on the PCB 15, and to dispose the second and third interface element 151, 152 in direct contact against the electronic components 24.

In this last case, since they are disposed in contact against the electronic components 24 of the memory module 20, the second and third interface element 151, 152 absorb the heat generated by the latter and transfer it to the rigid element 153, which, since it too is heat-conductive, provides to transfer the heat to the first interface element 150. The latter is in its turn in contact with the cold plate 25 which performs the necessary heat exchange. In this form of embodiment, in fact, the rigid element 153 not only performs the function of transferring the stresses, but also that of removing the heat from the side of the memory module 120 that is not directly facing toward the cold plate 25.

It is obvious that this form of embodiment can also be used with memory modules with components mounted only on a single face.

It is clear that modifications and/or additions of parts may be made to the liquid cooling device for electronic cards as described heretofore, without departing from the field and scope of the present invention.

For example, in another form of embodiment (fig. 6), it may be provided that, instead of associating the first 150, the second 151 and the third interface element 152 to the rigid element 153 as described with reference to fig. 5, the rigid element 153, made of highly heat-conductive material, for example metal, is coated by a film of material with high deformability and heat conductivity for the whole of its surface, both internal and external, so as to constitute a layer of interface 250 that substantially performs the same functions as the first 150, second 151 and third interface element 152.

In particular, the material which the layer of interface 250 is made of is the same as that of the interface elements described before, and is obtained with covering processes, for example overmolding. This solution is particularly economical when a large number of pieces are to be produced.

## Claims

1. Liquid cooling device for electronic cards (11) comprising a plurality of electronic modules (20, 20a, 20b; 120), such as memory modules or electronic components similar or comparable to memory modules, associated to a printed circuit board (15) which comprises support elements (37) configured to position said electronic modules (20, 20a, 20b; 120) inclined with respect to said printed circuit board (15) by a first acute angle (α), said electronic cards (11) further comprising connection elements (17) of a shape mating with said electronic modules (20, 20a, 20b; 120), so as to house inside them part of said electronic modules (20, 20a, 20b; 120) for connection to said printed circuit board (15), and wherein said liquid cooling device comprises at least a plate-type heat exchange means (25) in order to cool in contact at least a portion of each of said electronic modules (20, 20a, 20b; 120) protruding from a corresponding connection element (17) and bearing one or more electronic components (24) to be cooled, wherein said heat exchange means (25) is provided with at least a cooling circuit (27) comprising pipes (29) which extend parallel to the longitudinal development of the connection elements (17) of the electronic modules (20, 20a, 20b; 120) and through which a cooling liquid is able to pass, said heat exchange means (25) having a heat exchange surface (31) which can be positioned, when in use, substantially parallel to said printed circuit board (15), wherein said heat exchange surface (31) comprises a plurality of cavities (30) which develop in a main direction substantially parallel to said pipes (29), each cavity having at least a contact surface (32) inclined with respect to said heat exchange surface (31) by a second acute angle (β), and wherein interposition means (26, 26a, 26b; 126) are provided, which can be inserted in said cavities (30) to be interposed between said contact surfaces (32) and said support elements (37), so as to each cooperate directly in contact with both the contact surface (32) of the corresponding cavity (30) of said heat exchange surface (31) and also with the corresponding portion of each of said electronic modules (20, 20a, 20b; 120) protruding from said connection elements (17) which has said electronic components (24), wherein said interposition means (26, 26a, 26b; 126) comprises at least a first interface element (35; 150; 250) and a substantially rigid interposition element (36; 153),
wherein said first interface element (35; 150; 250) is made of high deformability heat-conductive material and is interposed, in direct contact with said contact surface (32), between a first surface to be cooled of the corresponding electronic module (20, 20a, 20b; 120) and said contact surface (32),
further wherein said interposition element (36; 153) is interposed between said electronic module (20, 20a, 20b; 120) and said support element and is shaped to cover a top end and a second surface, opposite said first surface, of the corresponding electronic module (20, 20a, 20b; 120), so as to completely surround at least said corresponding portion of said electronic modules (20, 20a, 20b; 120) which has said electronic components (24).

2. Device as in claim 1, wherein said first interface element (35) and said interposition element (36) are made in a single body and conformed U shaped in order to at least partly surround said electronic module (20, 20a, 20b).

3. Device as in claim 1, wherein said interposition element (153) is conformed to surround said electronic module (120) when in use, wherein a second interface element (151) and a third interface element (152) are associated, internally on opposite sides, to said interposition element (153) and are suitable to contact said electronic component (120), and wherein said interposition element (153) is disposed in contact externally, on one side, with said first interface element (150) and, on the opposite side, with said support element (37).

4. Device as in claim 1, wherein said interposition element (153) is conformed substantially U shaped so as to at least partly surround said electronic module (20a, 20b), and wherein said first interface element comprises an interface layer (250) having high deformability which covers both the internal surface and the external surface of said interposition element (153).

5. Device as in any claim hereinbefore, wherein said second angle of inclination (β) of the contact surface (32) is substantially equal to said first angle of inclination (α) of the electronic modules (20, 20a, 20b; 120).

6. Device as in any claim hereinbefore, wherein said second angle (β) has an amplitude comprised between 10° and 40°, advantageously between 20° and 40°, even more advantageously between 20° and 25°.

7. Device as in any claim hereinbefore, wherein said support elements comprise spacer elements (37) protruding from said printed circuit board (15) and configured to support the portions of each of said electronic modules (20, 20a, 20b; 120) protruding from said connection elements (17) which have said electronic components (24), in such a manner as to support the stresses imposed by said heat exchange means (25) in contact and to discharge them onto said printed circuit board (15).

8. Device as in any claim hereinbefore, wherein each of said connection elements (17) is provided with a connection portion (21) connecting to the printed circuit board (15).

9. Device as in any claim hereinbefore, wherein each of said connection elements (17) is provided with an insertion portion (22) provided with a slot (23) in which part of said electronic modules (20, 20a, 20b; 120) are housed.

10. Device as in claim 9, wherein the portions of each of said electronic modules (20, 20a, 20b, 120) protruding from said connection elements (17) which have said electronic components (24) protrude from the corresponding slots (23) of the insertion portions (22) of the connection elements (17).

11. Device as in any claim hereinbefore, wherein said connection elements (17) are disposed in series so as to position said electronic modules (20, 20a, 20b; 120) inclined and partly overlapping at top and tail-end, wherein, considering a pair of contiguous and overlapping connection elements (17), the interposition means (26, 26a, 26b; 126) associated to a determinate first connection element (17) overlapping a second connection element (17) press directly and rest on the connection element below (17).

12. Device as in claims 8 and 11, wherein said interposition means (26, 26a, 26b; 126) associated to the first connection element (17) press and rest directly on the connection portion (21) of the connection element below (17).

13. Electronic card comprising a cooling device (10) as in any claim hereinbefore.

14. Liquid cooling device for electronic cards (11) comprising a plurality of electronic modules (20, 20a, 20b; 120), such as memory modules or electronic components similar or comparable to memory modules, associated to a printed circuit board (15) which comprises support elements (37) configured to position said electronic modules (20, 20a, 20b; 120) inclined with respect to said printed circuit board (15) by a first acute angle (a), said electronic cards (11) further comprising connection elements (17) of a shape mating with said electronic modules (20, 20a, 20b; 120), so as to house inside them part of said electronic modules (20, 20a, 20b; 120) for connection to said printed circuit board (15), and wherein said liquid cooling device comprises at least a plate-type heat exchange means (25) in order to cool in contact at least a portion of each of said electronic modules (20, 20a, 20b; 120) protruding from a corresponding connection element (17) and bearing one or more electronic components (24) to be cooled, wherein said heat exchange means (25) is provided with at least a cooling circuit (27) comprising pipes (29) which extend parallel to the longitudinal development of the connection elements (17) of the electronic modules (20, 20a, 20b; 120) and through which a cooling liquid is able to pass, said heat exchange means (25) having a heat exchange surface (31) which can be positioned, when in use, substantially parallel to said printed circuit board (15), wherein said heat exchange surface (31) comprises a plurality of cavities (30) which develop in a main direction substantially parallel to said pipes (29), each cavity having at least a contact surface (32) inclined with respect to said heat exchange surface (31) by a second acute angle (β), and wherein interposition means (26, 26a, 26b; 126) are provided, which can be inserted in said cavities (30) to be interposed between said contact surfaces (32) and said support elements, so as to each cooperate directly in contact with both the contact surface (32) of the corresponding cavity (30) of said heat exchange surface (31) and also with the corresponding portion of each of said electronic modules (20, 20a, 20b; 120) protruding from said connection elements (17) which has said electronic components (24), wherein, considering a pair of contiguous and overlapping connection elements (17), the interposition means (26, 26a, 26b; 126) associated to a determinate first connection element (17) overlapping a second connection element (17) press directly and rest on the connection element below (17),
wherein said interposition means (26, 26a, 26b; 126) comprises a substantially rigid interposition element (36; 153) which is interposed between said electronic module (20, 20a, 20b; 120) and said support element (37) and is shaped to cover a top end and a second surface of the corresponding electronic module (20, 20a, 20b; 120) which is opposite a first surface to be cooled of the corresponding electronic module (20, 20a, 20b; 120), so as to completely surround at least said corresponding portion of said electronic modules (20, 20a, 20b; 120) which has said electronic components (24).

15. Device according to claim 14, wherein each of said connection elements (17) is provided with a connection portion (21) connecting to the printed circuit board (15), said connection elements (17) being disposed in series so as to position said electronic modules (20, 20a, 20b; 120) inclined and partly overlapping at top and tail-end, and in that said interposition means (26, 26a, 26b; 126) associated to the first connection element (17) press and rest directly on the connection portion (21) of the connection element below (17).

## Patentansprüche

1. Flüssigkeitskühlungsvorrichtung für elektronische Karten (11) umfassend eine Vielzahl von elektronischen Modulen (20, 20a, 20b; 120), wie z.B. Speichermodulen oder Speichermodulen ähnlichen oder damit vergleichbaren elektronischen Komponenten, die mit einer gedruckten Leiterplatte (15) verbunden sind, die Stützelemente (37) umfasst, welche so gestaltet sind, um die genannten elektronischen Module (20, 20a, 20b; 120) geneigt zur genannten gedruckten Leiterplatte (15) um einen ersten spitzen Winkel (α) zu positionieren, wobei die genannten Karten (11) ferner Verbindungselemente (17) mit einer Form umfassen, die zu den genannten elektronischen Modulen (20, 20a, 20b; 120) passt, so dass in ihrem Inneren ein Teil der genannten elektronischen Module (20, 20a, 20b; 120) zur Verbindung mit der genannten gedruckten Leiterplatte (15) aufgenommen wird, und worin die genannte Flüssigkeitskühlungsvorrichtung zumindest ein plattenartiges Wärmeaustauschmittel (25) umfasst, um in Berührung zumindest einen Abschnitt von jedem der genannten elektronischen Module (20, 20a, 20b; 120) zu kühlen, der aus einem entsprechenden Verbindungselement (17) herausragt und eine oder mehrere, zu kühlende elektronische Komponenten (24) trägt, worin das genannte Wärmeaustauschmittel (25) zumindest mit einem Kühlkreislauf (27) versehen ist, der Rohrleitungen (29) umfasst, die sich parallel zum Längsverlauf der Verbindungselemente (17) der elektronischen Module (20, 20a, 20b; 120) erstrecken und die von einer Kühlflüssigkeit durchströmt werden können, wobei das genannte Wärmeaustauschmittel (25) eine Wärmeaustauschfläche (31) aufweist, die, im Gebrauch, im Wesentlichen parallel zur genannten gedruckten Leiterplatte (15) positioniert werden kann, worin die genannte Wärmeaustauschfläche (31) eine Vielzahl von Hohlräumen (30) umfasst, die in einer Hauptrichtung im Wesentlichen parallel zu den genannten Rohrleitungen (29) verlaufen, wobei jeder Hohlraum zumindest eine Kontaktfläche (32) aufweist, die im Hinblick auf die genannte Wärmeaustauschfläche (31) um einen zweiten spitzen Winkel (β) geneigt ist, und worin Zwischenschaltungsmittel (26, 26a, 26b; 126) vorgesehen sind, die in die genannten Hohlräume (30) eingefügt werden können, um zwischen den genannten Kontaktflächen (32) und den genannten Stützelementen (37) zwischengeschaltet zu werden, so dass jedes unmittelbar im Kontakt sowohl mit der Kontaktfläche (32) des jeweiligen Hohlraums (30) der genannten Wärmeaustauschfläche (31) als auch mit dem entsprechenden Abschnitt von jedem der genannten elektronischen Module (20, 20a, 20b; 120) zusammenarbeitet, der aus den genannten Verbindungselementen (17) herausragt, der die genannten elektronischen Komponenten (24) aufweist, worin die genannten Zwischenschaltungsmittel (26, 26a, 26b; 126) zumindest ein erstes Schnittstellenelement (35; 150; 250) und ein im Wesentlichen starres Zwischenschaltungselement (36; 153) umfassen, worin das genannte erste Schnittstellenelement (35; 150; 250) aus einem hoch verformbaren Wärmeleitmaterial besteht und, in direktem Kontakt mit der genannten Kontaktfläche (32), zwischen einer ersten, zu kühlenden Fläche des entsprechenden elektronischen Moduls (20, 20a, 20b; 120) und der genannten Kontaktfläche (32) zwischengeschaltet ist, ferner worin das genannte Zwischenschaltungselement (36; 153) zwischen dem genannten elektronischen Modul (20, 20a, 20b; 120) und dem genannten Stützelement zwischengeschaltet ist und so geformt ist, um ein oberes Ende und eine zweite, der genannten ersten Fläche gegenüberliegende Fläche des entsprechenden elektronischen Moduls (20, 20a, 20b; 120) zu decken, um zumindest den genannten entsprechenden Abschnitt der genannten elektronischen Module (20, 20a, 20b; 120), der die genannten elektronischen Komponenten (24) aufweist, vollständig zu umgeben.

2. Vorrichtung nach Anspruch 1, worin das genannte erste Schnittstellenelement (35) und das genannte Zwischenschaltungselement (36) in einem Einzelkörper und U-förmig ausgebildet sind, um das genannte elektronische Modul (20, 20a, 20b) zumindest teilweise zu umgeben.

3. Vorrichtung nach Anspruch 1, worin das genannte Zwischenschaltungselement (153) so ausgebildet ist, um das genannte elektronische Modul (120) im Gebrauch zu umgeben, worin ein zweites Schnittstellenelement (151) und ein drittes Schnittstellenelement (152), innen auf gegenüberliegenden Seiten, mit dem genannten Zwischenschaltungselement (153) verbunden sind und dazu geeignet sind, die genannte elektronische Komponente (120) zu berühren, und worin das genannte Zwischenschaltungselement (153) außen, an einer Seite, im Kontakt mit dem genannten ersten Schnittstellenelement (150) und, an der gegenüberliegenden Seite, mit dem genannten Stützelement (37) angeordnet ist.

4. Vorrichtung nach Anspruch 1, worin das genannte Zwischenschaltungselement (153) im Wesentlichen U-förmig ausgebildet ist, um das genannte elektronische Modul (20a, 20b) zumindest teilweise zu umgeben, und worin das genannte erste Schnittstellenelement eine Schnittstellenschicht (250) mit hoher Verformbarkeit umfasst, die sowohl die Innenfläche als auch die Außenfläche des genannten Zwischenschaltungselements (153) deckt.

5. Vorrichtung nach einem der vorhergehenden Ansprüche, worin der genannte zweite Neigungswinkel (β) der Kontaktfläche (32) dem genannten ersten Neigungswinkel (α) der elektronischen Module (20, 20a, 20b; 120) im Wesentlichen gleich ist.

6. Vorrichtung nach einem der vorhergehenden Ansprüche, worin der genannte zweite Winkel (β) eine Weite zwischen 10° und 40°, vorteilhafterweise zwischen 20° und 40°, und noch vorteilhafter zwischen 20° und 25° aufweist.

7. Vorrichtung nach einem der vorhergehenden Ansprüche, worin die genannten Stützelemente Abstandselemente (37) umfassen, die aus der genannten gedruckten Leiterplatte (15) herausragen und so ausgebildet sind, um die Abschnitte von jedem der genannten elektronischen Module (20, 20a, 20b; 120), die aus den genannten Verbindungselementen (17) herausragen, die die genannten elektronischen Komponenten (24) aufweisen, derart zu stützen, um den Beanspruchungen standzuhalten, die von den genannten, im Kontakt stehenden Wärmeaustauschmitteln (25) verursacht werden, und sie auf die genannte gedruckte Leiterplatte (15) zu entladen.

8. Vorrichtung nach einem der vorhergehenden Ansprüche, worin jedes der genannten Verbindungselemente (17) mit einem Verbindungsabschnitt (21) versehen ist, der mit der genannten gedruckten Leiterplatte (15) verbunden ist.

9. Vorrichtung nach einem der vorhergehenden Ansprüche, worin jedes der genannten Verbindungselemente (17) mit einem Einführungsabschnitt (22) versehen ist, der einen Schlitz (23) aufweist, in welchem ein Teil der genannten elektronischen Module (20, 20a, 20b; 120) aufgenommen ist.

10. Vorrichtung nach Anspruch 9, worin die Abschnitte von jedem der genannten elektronischen Module (20, 20a, 20b, 120), die aus den genannten Verbindungselementen (17) herausragen, die die genannten elektronischen Komponenten (24) aufweisen, aus den entsprechenden Schlitzen (23) der Einführungsabschnitte (22) der Verbindungselemente (17) herausragen.

11. Vorrichtung nach einem der vorhergehenden Ansprüche, worin die genannten Verbindungselemente (17) der Reihe nach angeordnet sind, um die genannten elektronischen Module (20, 20a, 20b; 120) geneigt und teilweise am oberen Ende und am hinteren Ende überlappend zu positionieren, worin, wenn ein Paar von angrenzenden und überlappenden Verbindungselementen (17) berücksichtigt wird, die Zwischenschaltungsmittel (26, 26a, 26b; 126), die mit einem bestimmten ersten Verbindungselement (17), das ein zweites Verbindungselement (17) überlappt, verbunden sind, das darunter liegende Verbindungselement (17) direkt drücken und daran anliegen.

12. Vorrichtung nach den Ansprüchen 8 und 11, worin die genannten Zwischenschaltungsmittel (26, 26a, 26b; 126), die mit dem ersten Verbindungselement (17) verbunden sind, den Verbindungsabschnitt (21) des darunter liegenden Verbindungselementes (17) drücken und direkt daran anliegen.

13. Elektronische Karte umfassend eine Kühlungsvorrichtung (10) nach einem der vorhergehenden Ansprüche.

14. Flüssigkeitskühlungsvorrichtung für elektronische Karten (11) umfassend eine Vielzahl von elektronischen Modulen (20, 20a, 20b; 120), wie z.B. Speichermodulen oder Speichermodulen ähnlichen oder damit vergleichbaren elektronischen Komponenten, die mit einer gedruckten Leiterplatte (15) verbunden sind, die Stützelemente (37) umfasst, welche so gestaltet sind, um die genannten elektronischen Module (20, 20a, 20b; 120) geneigt zur genannten gedruckten Leiterplatte (15) um einen ersten spitzen Winkel (a) zu positionieren, wobei die genannten Karten (11) ferner Verbindungselemente (17) mit einer Form umfassen, die zu den genannten elektronischen Modulen (20, 20a, 20b; 120) passt, so dass in ihrem Inneren ein Teil der genannten elektronischen Module (20, 20a, 20b; 120) zur Verbindung mit der genannten gedruckten Leiterplatte (15) aufgenommen wird, und worin die genannte Flüssigkeitskühlungsvorrichtung zumindest ein plattenartiges Wärmeaustauschmittel (25) umfasst, um in Berührung zumindest einen Abschnitt von jedem der genannten elektronischen Module (20, 20a, 20b; 120) zu kühlen, der aus einem entsprechenden Verbindungselement (17) herausragt und eine oder mehrere, zu kühlende elektronische Komponenten (24) trägt, worin das genannte Wärmeaustauschmittel (25) zumindest mit einem Kühlkreislauf (27) versehen ist, der Rohrleitungen (29) umfasst, die sich zum Längsverlauf der Verbindungselemente (17) der elektronischen Module (20, 20a, 20b; 120) parallel erstrecken und die von einer Kühlflüssigkeit durchströmt werden können, wobei das genannte Wärmeaustauschmittel (25) eine Wärmeaustauschfläche (31) aufweist, die, im Gebrauch, im Wesentlichen parallel zur genannten gedruckten Leiterplatte (15) positioniert werden kann, worin die genannte Wärmeaustauschfläche (31) eine Vielzahl von Hohlräumen (30) umfasst, die in einer Hauptrichtung im Wesentlichen parallel zu den genannten Rohrleitungen (29) verlaufen, wobei jeder Hohlraum zumindest eine Kontaktfläche (32) aufweist, die im Hinblick auf die genannte Wärmeaustauschfläche (31) um einen zweiten spitzen Winkel (β) geneigt ist, und worin Zwischenschaltungsmittel (26, 26a, 26b; 126) vorgesehen sind, die in die genannten Hohlräume (30) eingefügt werden können, um zwischen den genannten Kontaktflächen (32) und den genannten Stützelementen zwischengeschaltet zu werden, so dass jedes unmittelbar im Kontakt sowohl mit der Kontaktfläche (32) des jeweiligen Hohlraums (30) der genannten Wärmeaustauschfläche (31) als auch mit dem entsprechenden Abschnitt von jedem der genannten elektronischen Module (20, 20a, 20b; 120) zusammenarbeitet, der aus den genannten Verbindungselementen (17) herausragt, der die genannten elektronischen Komponenten (24) aufweist, worin, wenn ein Paar von angrenzenden und überlappenden Verbindungselementen (17) berücksichtigt wird, das Zwischenschaltungsmittel (26, 26a, 26b; 126), das mit einem bestimmten ersten Verbindungselement (17), das ein zweites Verbindungselement (17) überlappt, verbunden ist, das darunter liegende Verbindungselement (17) direkt drückt und daran anliegt, worin die genannten Zwischenschaltungsmittel (26, 26a, 26b; 126) ein im Wesentlichen starres Zwischenschaltungselement (36; 153) umfassen, das zwischen dem genannten elektronischen Modul (20, 20a, 20b; 120) und dem genannten Stützelement (37) zwischengeschaltet ist und so geformt ist, um ein oberes Ende und eine zweite Fläche des entsprechenden elektronischen Moduls (20, 20a, 20b; 120) zu decken, die einer ersten, zu kühlenden, Fläche des entsprechenden elektronischen Moduls (20, 20a, 20b; 120) gegenüberliegt, um zumindest den genannten entsprechenden Abschnitt der genannten elektronischen Module (20, 20a, 20b; 120), der die genannten elektronischen Komponenten (24) aufweist, vollständig zu umgeben.

15. Vorrichtung nach Anspruch 14, worin jedes der genannten Verbindungselemente (17) mit einem Verbindungsabschnitt (21) versehen ist, der mit der genannten gedruckten Leiterplatte (15) verbunden ist, wobei die genannten Verbindungselemente (17) der Reihe nach angeordnet sind, um die genannten elektronischen Module (20, 20a, 20b; 120) geneigt und teilweise am oberen Ende und am hinteren Ende überlappend zu positionieren, worin das genannte Zwischenschaltungsmittel (26, 26a, 26b; 126), das mit dem ersten Verbindungselement (17) verbunden ist, den Verbindungsabschnitt (21) des darunter liegenden Verbindungselementes (17) drückt und direkt daran anliegt.

## Revendications

1. Dispositif de refroidissement liquide pour cartes électroniques (11) comportant une pluralité de modules électroniques (20, 20a, 20b; 120), tels que des modules de mémoire ou des composants électroniques analogues ou comparables à des modules de mémoire, associés à une carte de circuit imprimé (15) comportant des éléments de support (37) configurés pour positionner lesdits modules électroniques (20, 20a, 20b; 120) inclinés par rapport à ladite carte de circuit imprimé (15) par un premier angle aigu (α), lesdites cartes électroniques (11) comportant également des éléments de connexion (17) ayant une forme correspondant à celle desdits modules électroniques (20, 20a, 20b; 120), de manière à loger partiellement lesdits modules électroniques (20, 20a, 20b; 120) pour effectuer une connexion avec ladite carte de circuit imprimé (15), et dans lequel ledit dispositif de refroidissement liquide comporte au moins un moyen d'échange thermique sous forme de plaque (25) pour refroidir par contact au moins une partie de chacun desdits modules électroniques (20, 20a, 20b; 120) faisant saillie d'un élément de connexion correspondant (17) et supportant un ou plusieurs composants électroniques (24) à refroidir, dans lequel ledit moyen d'échange thermique (25) est muni d'au moins un circuit de refroidissement (27) comportant des tuyaux (29) qui s'étendent parallèles à l'étendue longitudinale des éléments de connexion (17) des modules électroniques (20, 20a, 20b; 120) et à travers lequel peut circuler un liquide de refroidissement, ledit moyen d'échange thermique (25) présentant une surface d'échange thermique (31) pouvant être disposée, en utilisation, sensiblement parallèle à ladite carte de circuit imprimé (15), dans lequel ladite surface d'échange thermique (31) comporte une pluralité de cavités (30), s'étendant dans une direction principale sensiblement parallèle auxdits tuyaux (29), chaque cavité présentant au moins une surface de contact (32) inclinée par rapport à ladite surface d'échange thermique (31) par un second angle aigu (β), et dans lequel des moyens d'interposition (26, 26a, 26b; 126) sont prévus, pouvant être insérés dans lesdites cavités (30), pour être interposés entre lesdites surfaces de contact (32) et lesdits éléments de support (37), de manière à coopérer chacun directement en contact avec la surface de contact (32) de la cavité correspondante (30) de la dite surface d'échange thermique (31), et également avec la partie correspondante de chacun desdits modules électroniques (20, 20a, 20b; 120) faisant saillie desdits éléments de connexion (17), qui comporte lesdits composants électroniques (24), dans lequel lesdits moyens d'interposition (26, 26a, 26b; 126) comprennent au moins un premier élément d'interface (35; 150; 250) et un élément d'interposition sensiblement rigide (36; 153),
dans lequel ledit élément d'interface (35; 150; 250) est constitué d'un matériau thermoconducteur à haute déformabilité et est interposé en contact direct avec ladite surface de contact (32) entre une première surface à refroidir du module électronique correspondant (20, 20a, 20b; 120) et ladite surface de contact (32),
et en plus dans lequel ledit élément d'interposition (36; 153) est interposé entre ledit module électronique (20, 20a, 20b; 120) et ledit élément de support et a une forme lui permettant de couvrir une extrémité supérieure et une deuxième surface, opposée à ladite première surface, du module électronique correspondant (20, 20a, 20b; 120), de manière à entourer entièrement au moins ladite partie correspondante desdits modules électroniques (20, 20a, 20b; 120), qui comporte lesdits composants électroniques (24).

2. Dispositif selon la revendication 1, dans lequel ledit premier élément d'interface (35) et ledit élément d'interposition (36) sont réalisés d'un seul tenant et conformés en U pour entourer au moins en partie ledit module électronique (20, 20a, 20b).

3. Dispositif selon la revendication 1, dans lequel ledit élément d'interposition (153) est conformé pour entourer ledit module électronique (120), en utilisation, dans lequel un deuxième élément d'interface (151) et un troisième élément d'interface (152) sont associés à l'intérieur et sur des côtés opposés, audit élément d'interposition (153) et sont conçus pour entrer en contact avec ledit composant électronique (120), et dans lequel ledit élément d'interposition (153) est placé en contact extérieur, sur un côté, avec ledit premier élément d'interface (150) et sur le côté opposé, avec ledit élément de support (37).

4. Dispositif selon la revendication 1, dans lequel ledit élément d'interposition (153) est conformé sensiblement en U pour entourer au moins en partie ledit module électronique (20a, 20b), et dans lequel ledit premier élément d'interface comporte une couche d'interface (250) à haute déformabilité, couvrant la surface intérieure et la surface extérieure dudit élément d'interposition (153).

5. Dispositif selon n'importe laquelle des revendications précédentes, dans lequel ledit second angle d'inclinaison (β) de la surface de contact (32) est sensiblement égal audit premier angle d'inclinaison (α) des modules électroniques (20, 20a, 20b; 120).

6. Dispositif selon n'importe laquelle des revendications précédentes, dans lequel ledit second angle (β) a une amplitude comprise entre 10° et 40°, avantageusement entre 20° et 40°, plus avantageusement entre 20° et 25°.

7. Dispositif selon n'importe laquelle des revendications précédentes, dans lequel lesdits éléments de support (37) comprennent des éléments d'écartement faisant saillie de ladite carte de circuit imprimé (15) et configurés pour supporter les parties de chacun desdits modules électroniques (20, 20a, 20b; 120) qui font saillie desdits éléments de connexion (17) comportant lesdits composants électroniques (24), de manière à supporter les contraintes imposées par ledit moyen d'échange thermique (25) en contact, et à les décharger sur ladite carte de circuit imprimé (15).

8. Dispositif selon n'importe laquelle des revendications précédentes, dans lequel chacun desdits éléments de connexion (17) est muni d'une partie de connexion (21) avec la carte de circuit imprimé (15).

9. Dispositif selon n'importe laquelle des revendications précédentes, dans lequel chacun desdits éléments de connexion (17) est muni d'une partie d'insertion (22) pourvue d'une fente (23) dans laquelle sont logés partiellement lesdits modules électroniques (20, 20a, 20b; 120).

10. Dispositif selon la revendication 9, dans lequel les parties de chacun desdits modules électroniques (20, 20a, 20b; 120) qui font saillie desdits éléments de connexion (17) comportant lesdits composants électroniques (24) font saillie des fentes correspondantes (23) des parties d'insertion (22) des éléments de connexion (17).

11. Dispositif selon n'importe laquelle des revendications précédentes, dans lequel lesdits éléments de connexion (17) sont agencés en série pour positionner lesdits modules électroniques (20, 20a, 220b; 120) inclinés et partiellement superposés tête sur queue, dans lequel, étant donnée une paire d'éléments de connexion contigus et superposés (17) les moyens d'interposition (26, 26a, 26b; 126) associés à un premier élément de connexion donné (17) superposé à un deuxième élément de connexion (17) compriment directement et s'appuient sur l'élément de connexion sous-jacent (17).

12. Dispositif selon les revendications 8 et 11, dans lequel lesdits moyens d'interposition (26, 26a, 26b; 126) associés au premier élément de connexion (17) compriment et s'appuient directement sur la partie de connexion (21) de l'élément de connexion sous-jacent (17).

13. Carte électronique comportant un dispositif de refroidissement (10) selon n'importe laquelle des revendications précédentes.

14. Dispositif de refroidissement liquide pour cartes électroniques (11) comportant une pluralité de modules électroniques (20, 20a, 20b; 120), tels que des modules de mémoire ou des composants électroniques analogues ou comparables à des modules de mémoire, associés à une carte de circuit imprimé (15) comportant des éléments de support (37) configurés pour positionner lesdits modules électroniques (20, 20a, 20b; 120) inclinés par rapport à ladite carte de circuit imprimé (15) par un premier angle aigu (a), lesdites cartes électroniques (11) comportant également des éléments de connexion (17) ayant une forme correspondant à celle desdits modules électroniques (20, 20a, 20b; 120), de manière à loger partiellement lesdits modules électroniques (20, 20a, 20b; 120) pour effectuer une connexion avec ladite carte de circuit imprimé (15), et dans lequel ledit dispositif de refroidissement liquide comporte au moins un moyen d'échange thermique sous forme de plaque (25) pour refroidir par contact au moins une partie de chacun desdits modules électroniques (20, 20a, 20b; 120) faisant saillie d'un correspondant élément de connexion (17) et supportant un ou plusieurs composants électroniques (24) à refroidir, dans lequel ledit moyen d'échange thermique (25) est muni d'au moins un circuit de refroidissement (27) comportant des tuyaux (29) qui s'étendent parallèles à l'étendue longitudinale des éléments de connexion (17) des modules électroniques (20, 20a, 20b; 120) et à travers lequel peut circuler un liquide de refroidissement, ledit moyen d'échange thermique (25) présentant une surface d'échange thermique (31) pouvant être disposée, en utilisation, sensiblement parallèle à ladite carte de circuit imprimé (15), dans lequel ladite surface d'échange thermique (31) comporte une pluralité de cavités (30), s'étendant dans une direction principale sensiblement parallèle auxdits tuyaux (29), chaque cavité présentant au moins une surface de contact (32) inclinée par rapport à ladite surface d'échange thermique (31) par un second angle aigu (β), et dans lequel des moyens d'interposition (26, 26a, 26b; 126) sont prévus, pouvant être insérés dans lesdites cavités (30), pour être interposés entre lesdites surfaces de contact (32) et lesdits éléments de support, de manière à coopérer chacun directement en contact avec la surface de contact (32) de la cavité correspondante (30) de la dite surface d'échange thermique (31), et également avec la partie correspondante de chacun desdits modules électroniques (20, 20a, 20b; 120) faisant saillie desdits éléments de connexion (17), qui comporte lesdits composants électroniques (24),
dans lequel, étant donnée une paire d'éléments de connexion contigus et superposés (17) les moyens d'interposition (26, 26a, 26b; 126) associés à un premier élément de connexion donné (17) superposé à un deuxième élément de connexion (17) compriment directement et s'appuient sur l'élément de connexion sous-jacent (17),
et dans lequel lesdits moyens d'interposition (26, 26a, 26b; 126) comportent un élément d'interposition sensiblement rigide (36; 153), qui est interposé entre ledit module électronique (20, 20a, 20b; 120) et ledit élément de support (37) et a une forme lui permettant de couvrir une extrémité supérieure et une deuxième surface du module électronique correspondant (20, 20a, 20b; 120), opposée à ladite première surface à refroidir du module électronique correspondant (20, 20a, 20b; 120), de manière à entourer entièrement au moins ladite partie correspondante desdits modules électroniques (20, 20a, 20b; 120), qui comporte lesdits composants électroniques (24).

15. Dispositif selon la revendication 14, dans lequel chacun desdits éléments de connexion (17) est muni d'une partie de connexion (21) avec la carte de circuit imprimé (15), lesdits éléments de connexion (17) étant agencés en série pour positionner lesdits modules électroniques (20, 20a, 20b; 120) inclinés et partiellement superposés tête sur queue, et dans lequel lesdits moyens d'interposition (26, 26a, 26b; 126) associés au premier élément de connexion (17) compriment et s'appuient directement sur la partie de connexion (21) de l'élément de connexion sous-jacent (17).
